# EUROPÄISCHE PATENTSCHRIFT

(11) **EP 3 205 022 B1**
(45) Veröffentlichungstag und Bekanntmachung des Hinweises auf die Patenterteilung: **30.12.2020**
(21) Anmeldenummer: 15766753.6
(22) Anmeldetag: 17.09.2015
(51) Int. Cl.: H03K 17/969

(54) **BEDIENVORRICHTUNG, INSBESONDERE FÜR EIN ELEKTRONISCHES HAUSHALTSGERÄT**
OPERATING DEVICE, IN PARTICULAR FOR AN ELECTRONIC HOUSEHOLD APPLIANCE
DISPOSITIF DE COMMANDE, NOTAMMENT POUR APPAREIL MÉNAGER ÉLECTRONIQUE

(30) Priorität: 09.10.2014 DE 102014015003
(43) Veröffentlichungstag der Anmeldung: 16.08.2017
(73) Patentinhaber: Diehl AKO Stiftung & Co. KG, 88239 Wangen (DE)
(72) Erfinder: MAIGLER, Andreas, 88339 Bad Waldsee (DE); FUHGE, Bruno, 88147 Achberg (DE); HEIMANN, Uwe, 88239 Wangen (DE); FROMMELT, Thomas, 81243 München (DE)
(74) Vertreter: Diehl Patentabteilung
(86) Internationale Anmeldenummer: PCT/EP2015/001859
(87) Internationale Veröffentlichungsnummer: WO 2016/055139

(56) Entgegenhaltungen:
- EP-A1- 0 558 871
- DE-A1-102004 058 478
- US-A- 4 405 197
- US-B1- 6 246 808

## Beschreibung

Die vorliegende Erfindung betrifft eine Bedienvorrichtung, insbesondere eine Bedienvorrichtung für elektronische Haushaltsgeräte.

Für Bedienvorrichtungen sind verschiedene Arten von Bedienelementen mit unterschiedlichen Funktionsweisen bekannt. Bei den als Drucktasten ausgebildeten Bedienelementen kann man zum Beispiel zwischen berührungs- und/oder annäherungsempfindlichen Drucktasten (sog. "Touch Control") und durch Krafteinwirkung betätigbaren Drucktasten differenzieren, die jeweils mit verschiedenen Aufbauten und Funktionsweisen realisierbar sind.

In diesem Zusammenhang sind bei den durch Krafteinwirkung betätigbaren Drucktasten neben solchen mit einem mechanischen Betätigungselement insbesondere auch kapazitive Drucktasten (vgl. z.B. DE 10 2011 121 897 A1), induktive Drucktasten (vgl. z.B. EP 2 529 484 B1) und piezoelektrische Drucktasten (vgl. z.B. EP 2 063 533 B1) bekannt. Diese speziellen Drucktasten erfordern im Allgemeinen eine hohe Fertigungs- und Montagegenauigkeit mit kleinen Toleranzbereichen. Auf einem optischen Messprinzip beruhende Drucktasten sind aus der EP 0 558 871 A1 und der US 4,405,197 bekannt.

Es ist die Aufgabe der vorliegenden Erfindung, eine Bedienvorrichtung mit einer Anzahl durch Krafteinwirkung betätigbaren Drucktasten zu schaffen, welche möglichst eng nebeneinander positioniert und möglichst einfach aufgebaut sind.

Diese Aufgabe wird gelöst durch eine Bedienvorrichtung mit den Merkmalen des Anspruchs 1. Besonders bevorzugte Ausgestaltungen und Weiterbildungen der Erfindung sind Gegenstand der abhängigen Ansprüche.

Die Bedienvorrichtung der Erfindung weist auf: eine Abdeckplatte mit einer einem Benutzer zugewandten Benutzerseite, wobei die Abdeckplatte eine Anzahl voneinander getrennter Bedienabschnitte definiert und in diesen Bedienabschnitten elastisch verformbar und/oder bewegbar ausgestaltet ist; eine Trägerplatte, die auf einer der Benutzerseite abgewandten Seite der Abdeckplatte zu dieser beabstandet angeordnet ist; eine Anzahl Sensoren, die auf der Trägerplatte angeordnet und derart ausgestaltet und angeordnet ist, dass sie jeweils eine Abstandsänderung zur Abdeckplatte im Bereich eines der Anzahl der Bedienabschnitte der Abdeckplatte erfassen können; und eine Trennplatte, die auf der der Benutzerseite abgewandten Seite der Abdeckplatte angeordnet ist und in den Bereichen zwischen der Anzahl der Bedienabschnitte der Abdeckplatte die Abdeckplatte kontaktierende Stützwände aufweist, wobei eine Anzahl Sensoren, die auf der Trägerplatte angeordnet ist und derart ausgestaltet und angeordnet ist, dass sie jeweils eine Abstandsänderung zur Abdeckplatte im Bereich eines der Anzahl der Bedienabschnitte der Abdeckplatte erfassen können; die Anzahl der Sensoren auf der der Abdeckplatte zugewandten Seite der Trägerplatte angeordnet ist; auf der der Abdeckplatte zugewandten Seite der Trägerplatte ein Sensorgehäuse angeordnet ist, das eine Anzahl Aussparungen aufweist, in denen die Anzahl Sensoren aufgenommen ist; und die Trägerplatte, das Sensorgehäuse und die Trennplatte eine Baueinheit bilden, die vorzugsweise lösbar mit der Abdeckplatte verbunden ist.

Die erfindungsgemäße Bedienvorrichtung weist eine Abdeckplatte mit einer Anzahl Bedienabschnitte und eine Trägerplatte mit einer Anzahl Sensoren, die der Anzahl der Bedienabschnitte der Abdeckplatte zugeordnet ist, auf. Durch die Trennplatte mit den Stützwänden, die bevorzugt formstabil sind, in den Bereichen zwischen den Bedienabschnitten der Abdeckplatte können diese Zwischenbereiche abgestützt werden, sodass die Bedienabschnitte der Abdeckplatte zuverlässig voneinander separiert werden können. Diese Separation der Bedienabschnitte erlaubt eine engere Positionierung der Bedienabschnitte und dennoch eine zuverlässige Betätigung bzw. Betätigungserfassung derselben unabhängig voneinander.

Durch das Einfügen der Trennplatte mit den Stützwänden, die vorteilhafter Weise formstabil sind, zwischen die Abdeckplatte und die Sensoren kann das Design-Bauteil (d.h. die Abdeckplatte) von den technischen Bauteilen separiert werden. Hierdurch können Herstellungs-, Montage- und Logistikprozesse vereinfacht werden. Es besteht so die Möglichkeit, die technischen Bauteile als vorgeprüfte Bauteile an einen OEM zu liefern. Außerdem kann das Design-Bauteil bei Bedarf unabhängig von den technischen Bauteilen und damit einfacher variiert werden.

Die Abdeckplatte kann in diesem Zusammenhang grundsätzlich aus einem beliebigen Material (z.B. transparent oder lichtundurchlässig, elektrisch leitfähig oder elektrisch nicht leitend, etc.), mit beliebigen Dimensionierungen und mit einem beliebigen Design gefertigt sein. Bei der Abdeckplatte handelt es sich vorzugsweise um eine Bedienblende zum Beispiel eines elektronischen Haushaltsgeräts.

Die Bedienvorrichtung weist eine Anzahl Bedienabschnitte und eine Anzahl Sensoren auf. D.h. die Bedienvorrichtung weist wenigstens einen Bedienabschnitt, bevorzugt zwei, drei oder mehr, vorzugsweise eine Mehrzahl von Bedienabschnitten auf; und die Bedienvorrichtung weist wenigstens einen Sensor, bevorzugt zwei, drei oder mehr, vorzugsweise eine Mehrzahl von Sensoren auf. Vorzugsweise ist für jeden der Anzahl der Bedienabschnitte ein Sensor vorgesehen und ist jeder der Anzahl der Sensoren einem Bedienabschnitt zugeordnet. Andererseits weist die Bedienvorrichtung eine Abdeckplatte, eine Trägerplatte und eine Trennplatte auf, die jeweils der Anzahl der Bedienabschnitte und der Anzahl der Sensoren gemeinsam vorgesehen sind.

Die Bedienabschnitte sind vorzugsweise einstückig mit der Abdeckplatte ausgebildet, als separate Komponenten in die Abdeckplatte eingesetzt oder als separate Komponenten fest mit der Abdeckplatte verbunden. Die Bedienabschnitte definieren für den Benutzer jeweils ein Bedienelement der Bedienvorrichtung, das er zum Betätigen drücken muss. D.h. die Bedienabschnitte bilden jeweils eine durch Krafteinwirkung betätigbare Drucktaste. Die Bedienabschnitte sind vorzugsweise für den Benutzer kenntlich gemacht, bevorzugt durch eine spezielle Formgebung seiner Benutzerseite (haptische Kennzeichnung), eine Kennzeichnung mit Farben und/oder Symbolen, eine Hinterleuchtung, eine erkennbare Abgrenzung zur übrigen Abdeckplatte und dergleichen.

Die Bedienabschnitte sind durch eine Krafteinwirkung von der Benutzerseite der Abdeckplatte her zumindest teilweise elastisch verformbar und/oder bewegbar. Die elastische Verformbarkeit wird vorzugsweise durch eine spezielle Materialwahl und/oder eine spezielle Dimensionierung (insbes. In Dickenrichtung) der Bedienabschnitte erzielt. Die elastische Bewegbarkeit kann vorzugsweise durch eine gefederte Lagerung des Bedienabschnitts in einer Durchbrechung in der Abdeckplatte realisiert werden.

Die Anzahl der Bedienabschnitte der Abdeckplatte sind voneinander getrennt. Diese Trennung ist vorzugsweise durch eine gegenseitige Beabstandung verwirklicht. Die Abstände zwischen den verschiedenen Bedienabschnitten können im Wesentlichen gleich zueinander oder unterschiedlich bemessen sein. In den Zwischenbereichen zwischen den Bedienabschnitten weist die Bedienvorrichtung vorzugsweise keine Bedien- bzw. Betätigungsfunktionalität auf. Die Anzahl der Bedienabschnitte ist vorzugsweise entlang einer im Wesentlichen geraden Linie, entlang einer gebogenen Linie (z.B. Kreisform), in Matrixform oder als singulärer Bedienabschnitt angeordnet.

Die Trägerplatte ist vorzugsweise als eine Leiterplatte ausgestaltet. Die Anzahl der Sensoren ist auf einer der Abdeckplatte zugewandten Seite der Trägerplatte und/oder auf einer der Abdeckplatte abgewandten Seite der Trägerplatte angeordnet. Die Trägerplatte ist vorzugsweise im Wesentlichen parallel zur Abdeckplatte angeordnet. Auf der Trägerplatte ist zudem vorzugsweise eine Steuereinrichtung zum Ansteuern der Anzahl der Sensoren und Aufnehmen der Messsignale der Anzahl der Sensoren angeordnet.

Die Trennplatte weist in den Bereichen zwischen der Anzahl der Bedienabschnitte der Abdeckplatte die Abdeckplatte kontaktierende Stützwände auf, die bevorzugt formstabil sind. Vorzugsweise ist die gesamte Trennplatte formstabil ausgebildet. Der Begriff Formstabilität bezieht sich in diesem Zusammenhang auf eine stabil gleichbleibende Form und Dimension der Trennplatte bzw. ihrer Stützwände bei einer bestimmungsgemäßen Verwendung der Bedienvorrichtung, d.h. insbesondere bei bestimmungsgemäßen Krafteinwirkungen (z.B. für eine Betätigung der Drucktasten) und bestimmungsgemäßen Temperaturbereichen. Durch die formstabilen Stützwände kann eine Verformung bzw. Bewegung der Abdeckplatte in den Bereichen zwischen den Bedienabschnitten - unabhängig von der Ausgestaltung der Abdeckplatte in diesen Zwischenbereichen - unterdrückt oder zumindest stark eingeschränkt werden. So können die Drucktastenfunktionalität auf die Bedienabschnitte begrenzt und ein "Übersprechen" zwischen benachbarten Bedienabschnitten verhindert werden. Die Trennplatte ist vorzugsweise aus Metall oder einem Kunststoffmaterial gefertigt.

Die Bedienvorrichtung der Erfindung kann neben den durch Krafteinwirkung betätigbaren Drucktasten, deren Betätigung durch die Sensoren erfasst wird, optional weitere Bedienelemente mit anderen Funktionsweisen enthalten. Dabei können insbesondere berührungs- und/oder annäherungsempfindliche Tasten zum Einsatz kommen.

Das Sensorgehäuse ist vorzugsweise allen Sensoren der Bedienvorrichtung gemeinsam vorgesehen. Das Sensorgehäuse ist vorzugsweise platten- oder rahmenförmig ausgestaltet. Je nach Ausgestaltung der Sensoren weist das Sensorgehäuse für jeden der Sensoren eine oder mehrere Aussparungen auf (zum Beispiel eine Aussparung für einen Sender des Sensors und eine Aussparung für einen Empfänger des Sensors). Das Sensorgehäuse kann vorzugsweise dem mechanischen Schutz der Sensoren dienen. Außerdem kann das Sensorgehäuse vorzugsweise einer Trennung der Anzahl der Sensoren dienen, um zum Beispiel ein Übersprechen zwischen benachbarten Sensoren zu verhindern.

Die Verbindung von Trägerplatte, Sensorgehäuse und Trennplatte als (technische) Baueinheit einerseits mit der Abdeckplatte (Design-Bauteil) andererseits ist vorzugsweise lösbar ausgestaltet (z.B. Klemm-, Rast-, Steck- oder Schraubverbindung), um zum Beispiel ein einfacheres Austauschen der technischen Baueinheit zu ermöglichen.

Bei dieser Ausgestaltung sind das Sensorgehäuse und die Trennplatte bevorzugt integral miteinander ausgebildet (d.h. zum Beispiel einstückig ausgebildet oder dauerhaft miteinander verbunden). Hierdurch können Zusammenbau und Montage der Bedienvorrichtung vereinfacht werden.

In einer anderen bevorzugten Ausgestaltung der Erfindung bilden die Trägerplatte und das Sensorgehäuse eine (technische) erste Baueinheit und bilden die Trennplatte und die Abdeckplatte eine zweite (Design-)Baueinheit, wobei die beiden Baueinheiten miteinander verbunden sind. Diese Verbindung ist vorzugsweise lösbar ausgestaltet (z.B. Klemm-, Rast-, Steck- oder Schraubverbindung), um zum Beispiel ein einfacheres Austauschen der technischen Baueinheit zu ermöglichen.

In einer weiteren bevorzugten Ausgestaltung der Erfindung ist die Anzahl der Sensoren ausgestaltet, um eine Abstandsänderung zur Abdeckplatte mittels elektromagnetischer Strahlung zu erfassen. In einer ersten Ausführungsvariante der Erfindung ist die Abdeckplatte auf ihrer der Benutzerseite abgewandten Seite zumindest im Bereich der Bedienabschnitte mit einer Reflexionsfläche ausgebildet und weist die Trennplatte im Bereich der Bedienabschnitte Öffnungen auf. In einer zweiten Ausführungsvariante der Erfindung weist die Trennplatte auf ihrer der Abdeckplatte zugewandten Seite eine Deckplatte zum Schließen der Trennplatte auf, die mit der Abdeckplatte im Bereich der Bedienabschnitte in Kontakt steht, und ist die Deckplatte der Trennplatte auf ihrer der Benutzerseite abgewandten Seite zumindest im Bereich der Bedienabschnitte mit einer Reflexionsfläche ausgebildet. Vorzugsweise ist die Deckplatte der Trennplatte im Bereich der Bedienabschnitte elastisch verformbar bzw. bewegbar ausgebildet, sodass eine Verformung bzw. Bewegung der Bedienabschnitte auf die Deckplatte der Trennplatte übertragen werden können. In einer noch weiteren bevorzugten Ausgestaltung der Erfindung weist die Anzahl der Sensoren jeweils einen Sender zum Emittieren von elektromagnetischer Strahlung und einen Empfänger zum Erfassen der elektromagnetischen Strahlung auf, wobei die Empfänger der Sensoren jeweils derart angeordnet und/oder ausgestaltet sind, dass sie eine ortsaufgelöste Erfassung der von dem Sender emittierten und dann (an der Abdeckplatte oder an der Deckplatte der Trennplatte) reflektierten elektromagnetischen Strahlung ermöglichen.

Bei dieser Ausführungsform sind die Stützwände der Trennplatte vorzugsweise für die von den Sendern der Anzahl der Sensoren emittierte elektromagnetische Strahlung im Wesentlichen undurchlässig ausgebildet. Auf diese Weise kann bevorzugt ein Übersprechen zwischen benachbarten Drucktasten unterdrückt werden.

Bei der erfindungsgemäßen Bedienvorrichtung mit den elektromagnetischen Sensoren genügen minimale Verformungen bzw. Bewegungshübe der Bedienabschnitte, um eine Betätigung durch den Benutzer erfassen zu können, da bereits sehr kleine Veränderungen der Reflexionsorte an den Bedienabschnitten sehr unterschiedliche Ablenkungen der elektromagnetischen Strahlung bewirken. Die Betätigung der Bedienabschnitte kann daher sehr zuverlässig erkannt werden. Zudem dürfen bei dieser Konstruktion die Toleranzen bei Fertigung und Montage der Bauteile im Vergleich zu herkömmlichen, durch Krafteinwirkung betätigbaren Drucktasten mit kapazitiver, induktiver oder piezoelektrischer Funktionsweise größer sein. Da es für die Detektion einer Betätigung der Bedienabschnitte ausreicht, eine relative Veränderung des Erfassungsortes der reflektierten Strahlung zu erfassen, kann bei einer so aufgebauten Bedienvorrichtung auch ein Kalibriervorgang entfallen.

Bei der elektromagnetischen Strahlung handelt es sich vorzugsweise um optische Strahlung, bevorzugt im sichtbaren oder Infrarot-Wellenlängenbereich. Bei den Sendern handelt es sich vorzugsweise um Leuchtdioden, Laserdioden, Glühlampen, Halogenlampen oder dergleichen. Die Empfänger ermöglichen vorzugsweise eine ortsaufgelöste Erfassung der reflektierten Strahlung. Die Empfänger sind dementsprechend bevorzugt ausgewählt aus CCD-Chips, aktiven Pixelsensoren, Photodioden, Phototransistoren, etc. und Anordnungen solcher Elemente.

Die Reflexionsflächen der Bedienabschnitte der Abdeckplatte oder der Deckplatte sind so ausgestaltet, dass sie die von den Sensoren bzw. deren Sendern emittierte Strahlung zumindest teilweise reflektieren können. Diese Reflexionseigenschaft wird vorzugsweise erreicht durch eine spezielle Materialauswahl, eine spezielle Oberflächenstruktur, eine spezielle Oberflächenbehandlung (bevorzugt Beschichtung, etc.) der der Benutzerseite abgewandten Rückseite der Abdeckplatte bzw. der Deckplatte der Trennplatte oder dergleichen. Die Reflexionsflächen sind vorzugsweise nur im Bereich der Bedienabschnitte vorgesehen, können alternativ aber auch über die gesamte Abdeckplatte bzw. Trennplatte hinweg ausgebildet sein.

In einer noch weiteren bevorzugten Ausgestaltung der Erfindung ist auf der Trägerplatte wenigstens eine Lichtquelle angeordnet, weist die Abdeckplatte wenigstens einen lichtdurchlässigen Abschnitt auf und ist wenigstens ein Lichtleitelement vorgesehen, das von der wenigstens einen Lichtquelle emittiertes Licht zu dem wenigstens einen lichtdurchlässigen Abschnitt der Abdeckplatte leitet. Vorzugsweise ist das wenigstens eine Lichtleitelement integral mit dem Sensorgehäuse und/oder der Trennplatte ausgebildet bzw. in diese(s) integriert.

Zweckmäßiger Weise ist die Anzahl der Sensoren vergossen. Vorteilhaft hieran ist, dass die vergossenen Sensoren von Umwelteinflüssen abgeschirmt und dadurch widerstandsfähiger sind. Es können ein einzelne Sensoren oder alle Sensoren vergossen sein.

Als vorteilhafte Weiterbildung ist zwischen der Abdeckplatte und dem Sensor ein Lichtleitelement angeordnet. Durch die Verwendung eines Lichtleitelements wird vorteilhaft gewährleistet, dass elektromagnetische Strahlung störungsfrei zum Sensor hin oder vom Sensor weg geleitet wird. Bei dem Lichtleiter handelt es sich um einen für elektromagnetische Strahlung transmissiven Körper oder um einen Hohllichtleiter. Bevorzugt ist der Lichtleiter vergossen.

Gegenstand der Erfindung ist ferner ein elektronisches Haushaltsgerät mit wenigstens einer oben beschriebenen Bedienvorrichtung der Erfindung.

Bei dem elektronischen Haushaltsgerät handelt es sich vorzugsweise um ein Wäschebehandlungsgerät (Waschmaschine, Wäschetrockner, etc.), eine Spülmaschine, ein Kühl- und/oder Gefriergerät, ein Kochfeld, einen Herd, einen Mikrowellenofen, eine Dunstabzugshaube oder dergleichen.

Obige sowie weitere Merkmale und Vorteile der Erfindung werden aus der nachfolgenden Beschreibung bevorzugter, nicht-einschränkender Ausführungsbeispiele anhand der beiliegenden Zeichnung besser verständlich. Darin zeigen, zum Teil schematisch:
- Fig. 1: eine Schnittansicht einer Bedienvorrichtung gemäß einem ersten Ausführungsbeispiel der Erfindung;
- Fig. 2: eine starke vereinfachte Darstellung des Funktionsprinzips der Bedienvorrichtung gemäß einer bevorzugten Ausführungsvariante, wobei Teilfigur 2A den nicht betätigten Funktionszustand zeigt und Teilfigur 2B den betätigten Funktionszustand zeigt;
- Fig. 3: Teilschnittansichten einer Bedienvorrichtung mit einer Trennplatte gemäß einer ersten Ausführungsvariante der Erfindung (Teilfigur 3A) bzw. einer zweiten Ausführungsvariante der Erfindung (Teilfigur 3B);
- Fig. 4: eine Schnittansicht einer Bedienvorrichtung gemäß einem zweiten Ausführungsbeispiel der Erfindung; und
- Fig. 5: eine Schnittansicht einer Bedienvorrichtung gemäß einem dritten Ausführungsbeispiel der Erfindung.

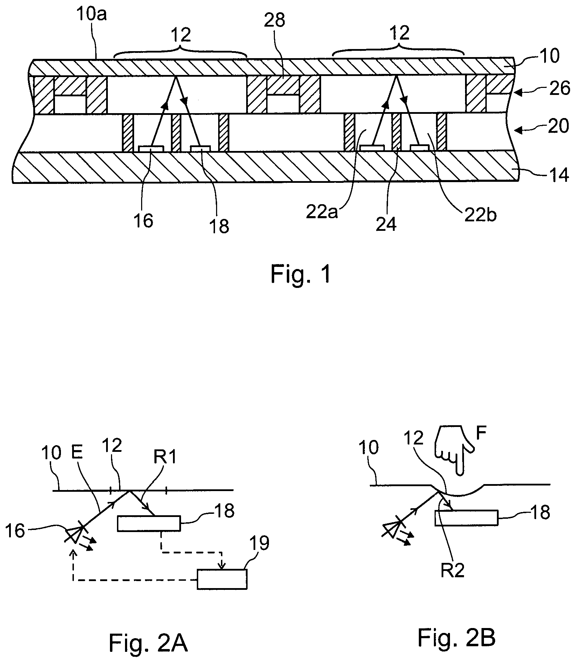

Bezug nehmend auf Fig. 1 und 2 wird nun ein erstes Ausführungsbeispiel einer erfindungsgemäß ausgestalteten Bedienvorrichtung näher erläutert.

Die Bedienvorrichtung weist eine Abdeckplatte 10 in Form einer Bedienblende auf. Die Abdeckplatte 10 ist beispielsweise aus einem opaken Kunststoffmaterial gefertigt. Die Abdeckplatte 10 hat eine dem Benutzer zugewandte Benutzerseite 10a (oben in Fig. 1), welche der Außenseite der Bedienblende entspricht, und eine dem Benutzer abgewandte Rückseite (unten in Fig. 1), welche der Innenseite der Bedienblende entspricht.

Die Abdeckplatte 10 weist mehrere nebeneinander angeordnete und zueinander beabstandete Bedienabschnitte 12 auf, die für den Benutzer jeweils ein Bedienelement definieren, das er betätigen kann. Die Bedienabschnitte 12 sind in die Abdeckplatte 10 integriert bzw. einteilig mit dieser ausgebildet oder als separate Komponenten in diese eingesetzt und wahlweise mit dieser verbunden. Wie ein Vergleich der Teilfiguren 2A und 2B zeigt, sind die Bedienabschnitte 12 jeweils durch eine Krafteinwirkung F von der Benutzerseite 10a her, zum Beispiel mit einem Finger des Benutzers, elastisch verformbar oder bewegbar ausgestaltet. D.h. nach Beendigung der Krafteinwirkung F kehren die Bedienabschnitte 12 wieder in ihren Ausgangszustand von Fig. 1 bzw. 2A zurück.

Die Bedienabschnitte 12 sind vorzugsweise für den Benutzer gekennzeichnet, damit dieser sie leichter auffinden und ihre Funktionaltäten identifizieren kann. Hierzu können die Bedienabschnitte 12 oder ihre Außenseiten selbst gekennzeichnet sein oder kann die Abdeckplatte 10 jeweils in der Nähe der Bedienabschnitte 12 gekennzeichnet sein. Die Kennzeichnung erfolgt zum Beispiel optisch durch Farben und/oder Symbole, haptisch durch Oberflächenstrukturen, elektrisch durch eine Hinterleuchtung oder Signallampen, oder dergleichen.

Die Bedienvorrichtung weist ferner eine Trägerplatte 14 in Form einer Leiterplatte auf. Diese Trägerplatte 14 ist im Wesentlichen parallel zur Abdeckplatte 10 ausgerichtet und auf der der Benutzerseite 10a abgewandten Seite der Abdeckplatte 10 beabstandet zu dieser angeordnet. Auf dieser Trägerplatte 14 sind, zum Beispiel auf ihrer der Abdeckplatte 10 zugewandten Seite, mehrere Sensoren 16, 18 angeordnet. Die Sensoren 16, 18 sind dabei entsprechend den Bedienabschnitten 12 angeordnet und verteilt und jeweils einem der mehreren Bedienabschnitte 12 der Abdeckplatte 10 zugeordnet.

In diesem Ausführungsbeispiel weisen die Sensoren 16, 18 jeweils einen Sender 16 zum Beispiel in Form einer Leuchtdiode und einen Empfänger 18 zum Beispiel in Form eines CCD-Chips auf. Die Sender 16 emittieren elektromagnetische Strahlung, vorzugsweise im sichtbaren oder Infrarot-Wellenlängenbereich, und die Empfänger 18 erfassen elektromagnetische Strahlung desselben Wellenlängenbereichs. Die mehreren Sensoren 16, 18 können wahlweise mit Strahlung in gleichen oder unterschiedlichen Wellenlängen(bereichen) arbeiten.

Wie in Fig. 1 und 2 dargestellt, trifft die von einem Sender 16 emittierte Strahlung E auf die Rückseite eines Bedienabschnitts 12 der Abdeckplatte 10. Die Bedienabschnitte 12 sind an ihrer der Benutzerseite 10a abgewandten Rückseite jeweils mit einer Reflexionsfläche 10b versehen. So wird die Strahlung E an einem Bedienabschnitt 12 reflektiert und die reflektierte Strahlung R1, R2 trifft dann auf den Empfänger 18 und wird von diesem erfasst.

Wie in Fig. 2 veranschaulicht, sind die Empfänger 18 ausgestaltet, um die elektromagnetische Strahlung ortsaufgelöst zu erfassen. Im Ausgangszustand von Teilfigur 2A, d.h. ohne Betätigung des Bedienabschnitts 12 durch den Benutzer, befindet sich der Bedienabschnitt 12 in seinem unverformten Ausgangszustand und reflektiert die Strahlung R1 zum Empfänger 18. Im Betätigungszustand von Teilfigur 2B, d.h. bei einer Krafteinwirkung F durch den Benutzer auf den Bedienabschnitt 12, ist der Bedienabschnitt 12 verformt und reflektiert die Strahlung R2 zum Empfänger 18. Der Vergleich der Teilfiguren 2A und 2B zeigt, dass selbst bei einer geringen Verformung des Bedienabschnitts 12 bereits eine sehr deutliche Veränderung des Erfassungsortes der reflektierten Strahlung R2 erfolgt. Diese relative Veränderung des Erfassungsortes wird von dem ortsauflösenden Empfänger 18 erfasst.

Die mit den Sendern 16 und den Empfängern 18 der mehreren Sensoren verbundene Steuereinrichtung 19 steuert die Sender 16 an und wertet die von den Empfängern 18 erzeugten Messsignale aus. Die mehreren Sensoren können wahlweise zeitgleich oder zeitlich zueinander versetzt (d.h. getaktet) betrieben werden. Die Steuereinrichtung 19 ist beispielsweise ebenfalls auf der Trägerplatte 14 angeordnet.

Wie in Fig. 1 dargestellt, sind die mehreren Sensoren in einem Sensorgehäuse 20 aufgenommen. Das Sensorgehäuse 20 ist im Wesentlichen platten- oder rahmenförmig ausgestaltet und auf der Trägerplatte 14 montiert. Das Sensorgehäuse 20 weist mehrere Aussparungen 22a, 22b zum Aufnehmen der Sensoren auf. Vorzugsweise sind Aussparungen 22a für die Sender 16 der Sensoren und Aussparungen 22b für die Empfänger 18 der Sensoren vorgesehen, welche jeweils durch Trennwände 24 voneinander getrennt sind. Das Sensorgehäuse 20 ist vorzugsweise aus einem Kunststoffmaterial gefertigt. Außerdem ist das Sensorgehäuse 20 bevorzugt für die von den Sensoren benutzte elektromagnetische Strahlung im Wesentlichen undurchlässig ausgebildet, um ein Übersprechen zwischen benachbarten Sensoren zu unterdrücken.

Zwischen der Abdeckplatte 10 und dem Sensorgehäuse 20 ist zudem eine Trennplatte 26 angeordnet. Die Trennplatte 26 ist im Wesentlichen platten- oder rahmenförmig ausgestaltet und steht mit der Abdeckplatte 10 in Kontakt. Die Trennplatte 26 weist mehrere Stützwände 28 auf, die bevorzugt formstabil sind. Diese Stützwände 28 sind in den Zwischenbereichen zwischen den Bedienabschnitten 12 der Abdeckplatte 10 vorgesehen. Durch eine Formstabilität und den Kontakt mit der Äbdeckplatte 10 unterstützen die Stützwände 28 die Abdeckplatte 10 in den Bereichen zwischen den Bedienabschnitten 12. Auf diese Weise können die Bedienabschnitte 12 der Abdeckplatte 10 zuverlässig separiert werden und kann so eine gegenseitige Beeinflussung zwischen benachbarten Bedienabschnitten 12 unterdrückt werden. Im Ergebnis lassen sich die Bedienabschnitte 12 sehr eng zueinander anordnen und dennoch zuverlässig unabhängig voneinander betätigen.

Die Trennplatte 26 vorzugsweise aus einem Kunststoffmaterial oder aus Metall gefertigt, und bevorzugt für die von den Sensoren benutzte elektromagnetische Strahlung im Wesentlichen undurchlässig ausgebildet, um ein Übersprechen zwischen benachbarten Sensoren zu unterdrücken.

Um die Produktions-, Montage- und Logistikprozesse zu vereinfachen, sind in einer Ausführungsvariante der Erfindung die Trägerplatte 14 mit den Sensoren 16, 18, das Sensorgehäuse 20 und die Trennplatte 26 zu einer Baueinheit zusammengefasst. Diese technische Baueinheit kann vorgefertigt, geprüft und dann zum Beispiel an einen OEM geliefert werden, um dort mit dem Design-Bauteil, das durch die Abdeckplatte 10 gebildet wird, verbunden zu werden. Um die Komponenten zum Beispiel zu Reparaturzwecken einfach trennen zu können, ist diese Verbindung bevorzugt lösbar ausgestaltet, zum Beispiel durch Klemmen, Verrasten, Verschrauben oder dergleichen.

In einer anderen Ausführungsvariante der Erfindung erfolgt die Trennung zwischen Technik und Design zwischen dem Sensorgehäuse 20 und der Trennplatte 26. Mit anderen Worten bilden die Trägerplatte 14 mit den Sensoren 16, 18 und das Sensorgehäuse eine erste Baueinheit und bilden die Trennplatte 26 und die Abdeckplatte 10 eine zweite Baueinheit. Auch diese beiden Baueinheiten sind dann bevorzugt lösbar miteinander verbunden.

In beiden erläuterten Ausführungsvarianten können die Komponenten einer Baueinheit zum Beispiel miteinander verklebt sein.

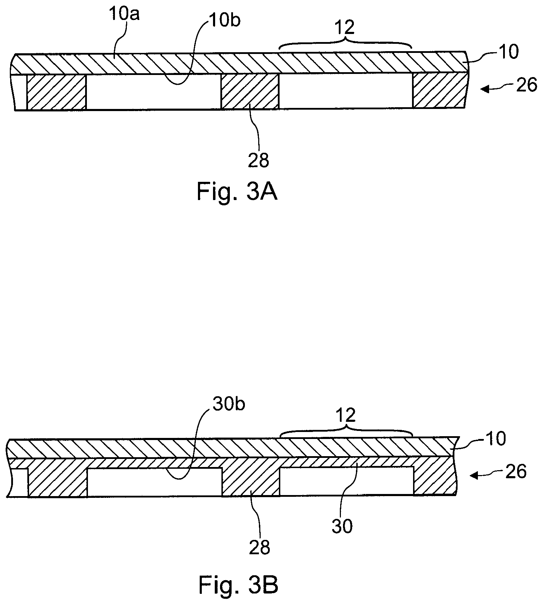

Bezug nehmend auf Fig. 3 werden zwei Ausführungsvarianten einer Trennplatte 26 näher erläutert, die in der Bedienvorrichtung von Fig. 1 zum Einsatz kommen können.

In der Ausführungsvariante, die in Teilfigur 3A dargestellt ist, ist die Trennplatte 26 im Bereich der Bedienabschnitte 12 der Abdeckplatte 10 durchbrochen, d.h. mit Öffnungen ausgestaltet. Dementsprechend sind die Bedienabschnitte 12 der Abdeckplatte 10 an ihrer der Benutzerseite 10a abgewandten Rückseite jeweils mit einer Reflexionsfläche 10b versehen. Die von den Sendern 16 emittierte Strahlung E durchläuft das Sensorgehäuse 20 und die Trennplatte 26, wird an den Reflexionsflächen 10b der Bedienabschnitte 12 reflektiert, durchläuft dann wieder die Trennplatte 26 und das Sensorgehäuse 10 und wird dann an den Empfängern 18 erfasst.

In der Ausführungsvariante von Teilfigur 3B ist die Trennplatte 26 auf ihrer der Abdeckplatte 10 zugewandten Seite geschlossen ausgebildet. Hierzu ist die Trennplatte 26 im Bereich der Bedienabschnitte 12 der Abdeckplatte 10 mit einer Deckplatte 30 ausgestaltet. Diese Deckplatte 30 steht in Kontakt mit der Abdeckplatte 10. Dementsprechend ist in dieser Variante nicht die Abdeckplatte 10, sondern die Deckplatte 30 im Bereich der Bedienabschnitt 12 an ihrer der Benutzerseite 10a abgewandten Rückseite mit einer Reflexionsfläche 30b versehen. Die von den Sendern 16 emittierte Strahlung E durchläuft das Sensorgehäuse 20 und die Trennplatte 26, wird an den Reflexionsflächen 30b der Deckplatte 30 12 reflektiert, durchläuft dann wieder die Trennplatte 26 und das Sensorgehäuse 10 und wird dann an den Empfängern 18 erfasst.

Bei dieser Ausführungsvariante wird eine Verformung oder Bewegung des Bedienabschnitts 12 der Abdeckplatte 10 durch den Kontakt auf die Deckplatte 30 der Trennplatte 26 übertragen. Dementsprechend ist die Deckplatte 30 der Trennplatte 26 im Bereich der Bedienabschnitte 12 bevorzugt elastisch verformbar bzw. bewegbar ausgebildet.

Die beiden Ausführungsvarianten der Fig. 3A und 3B sind auf alle Ausführungsbeispiele, insbesondere auch auf alle Ausführungsbeispiele der Fig. 1, 4 und 5 anwendbar.

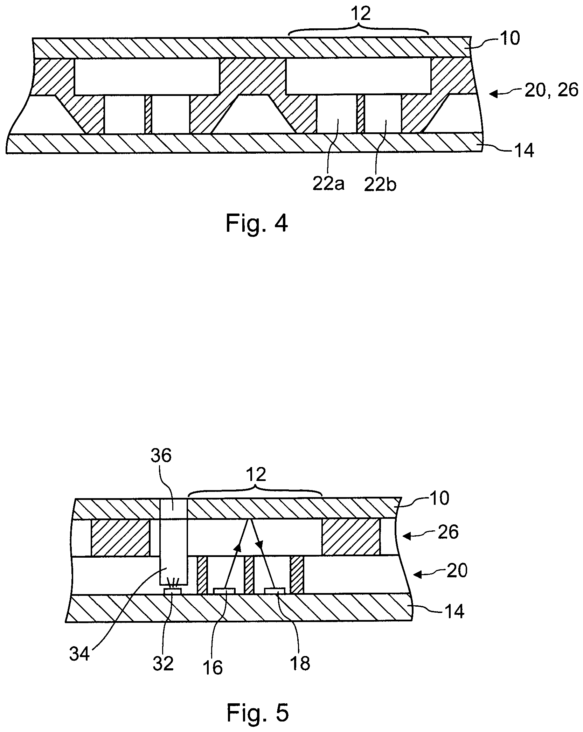

Fig. 4 zeigt ein zweites Ausführungsbeispiel einer erfindungsgemäßen Bedienvorrichtung. Gleiche oder entsprechende Komponenten sind mit den gleichen Bezugsziffern wie im ersten Ausführungsbeispiel versehen.

Im Ausführungsbeispiel von Fig. 4 sind das Sensorgehäuse 20 und die Trennplatte 26 integral miteinander ausgebildet. So können die beiden Komponenten 20, 26 beispielsweise einstückig miteinander gefertigt werden oder kann die eine Komponente an die andere Komponente angespritzt werden. Falls die beiden Komponenten aus unterschiedlichen Kunststoffmaterialien gefertigt werden sollen, kommen hierfür zum Beispiel 2K-Spritzverfahren in Frage.

Fig. 5 zeigt ein drittes Ausführungsbeispiel einer erfindungsgemäßen Bedienvorrichtung. Gleiche oder entsprechende Komponenten sind mit den gleichen Bezugsziffern wie im ersten Ausführungsbeispiel versehen.

Bei diesem Ausführungsbeispiel ist in der Bedienvorrichtung zusätzlich eine elektrische Signalkomponente vorgesehen. Auf diese Weise können zum Beispiel die Bedienabschnitte 12 für den Benutzer optisch gekennzeichnet werden, dem Benutzer einer optisches Feedback über eine Betätigung eines Bedienabschnitts gegeben werden, dem Benutzer Informationen über einen Betriebszustand der Bedienvorrichtung oder des jeweiligen Haushaltsgeräts gegeben werden, etc.

Auf der Trägerplatte 14 sind im Bereich neben den Sensoren 16, 18 Lichtquellen 32 zum Beispiel in Form von Leuchtdioden angeordnet. Das von den Lichtquellen 32 ausgesendete Licht wird mittels Lichtleitelementen 34 zur Abdeckplatte 34 transportiert, insbesondere zu lichtdurchlässigen Abschnitten 36 der Abdeckplatte 10. Diese lichtdurchlässigen Abschnitte 36 können zum Beispiel durch Öffnungen in der Abdeckplatte 10 oder durch ein lichtdurchlässiges Material gebildet werden.

Die Lichtleitelemente 34 sind zum Beispiel als separate Komponenten gefertigt und in entsprechende Durchbrechungen in dem Sensorgehäuse 20 und in der Trennplatte 26 eingesetzt. Alternativ können die Lichtleitelemente 34 auch integral mit dem Sensorgehäuse 20 und/oder der Trennplatte 26 ausgebildet sein, zum Beispiel in Form eines Kanals mit reflektierenden Seitenwänden durch das Sensorgehäuse 20 bzw. die Trennplatte 26 hindurch.

Während das Lichtleitelement 34 in dem Ausführungsbeispiel von Fig. 5 im Wesentlichen geradlinig und mit über die Länge im Wesentlichen gleichbleibender Querschnittsform und -größe ausgestaltet ist, ist die Erfindung nicht auf diese Ausführungsform beschränkt. So können die Lichtleitelemente 34 zum Beispiel auch ein oder mehrere Krümmungen oder Biegungen enthalten, einen großflächigere, austrittseitige Stirnfläche aufweisen, etc.

Die Lichtquellen 32 und die Lichtleitelemente 34 können wahlweise für alle Bedienabschnitte 12 der Abdeckplatte 10 oder nur für einen Teil dieser Bedienabschnitte 12 vorgesehen sein. Auch können mehrere Lichtleitelemente 34 von verschiedenen Bedienabschnitten 12 mit gemeinsamen Lichtquellen 32 gekoppelt sein.

Obwohl nicht dargestellt, können in weiteren Ausführungsbeispielen die der Benutzerseite 10a abgewandten Rückseiten der Bedienabschnitte 12 der Abdeckplatte 10 von der gezeigten planen Gestalt abweichen, um den Effekt der Veränderung des Erfassungsortes der reflektierten Strahlung R1, R2 an den Empfängern 18 zu verstärken. In gleicher Weise können auch die der Benutzerseite 10a abgewandten Rückseiten der Deckplatte 30 der Trennplatte 26 von der gezeigten planen Gestalt abweichen, um den genannten Effekt zu verstärken.

Die vorstehende Beschreibung der Figuren 1 bis 5 ist analog auf ein Ausführungsbeispiel mit nur einem Bedienabschnitt 12 übertragbar.

### BEZUGSZIFFERNLISTE

- 10: Abdeckplatte
- 10a: Benutzerseite
- 10b: Reflexionsfläche
- 12: Bedienabschnitt
- 14: Trägerplatte
- 16: Sender eines Sensors
- 18: Empfänger eines Sensors
- 19: Steuereinrichtung
- 20: Sensorgehäuse
- 22a: Aussparung für Sender
- 22b: Aussparung für Empfänger
- 24: Trennwand
- 26: Trennplatte
- 28: Stützwand
- 30: Deckplatte
- 30b: Reflexionsfläche
- 32: Lichtquelle
- 34: Lichtleitelement
- 36: lichtdurchlässiger Abschnitt
- E: emittierte Strahlung
- F: Krafteinwirkung
- R1: reflektierte Strahlung
- R2: reflektierte Strahlung

## Patentansprüche

1. Bedienvorrichtung, insbesondere für ein elektronisches Haushaltsgerät, aufweisend:
eine Abdeckplatte (10) mit einer einem Benutzer zugewandten Benutzerseite (10a), wobei die Abdeckplatte (10) eine Anzahl voneinander getrennter Bedienabschnitte (12) definiert und in diesen Bedienabschnitten (12) elastisch verformbar und/oder bewegbar ausgestaltet ist;
eine Trägerplatte (14), die auf einer der Benutzerseite (10a) abgewandten Seite der Abdeckplatte (10) zu dieser beabstandet angeordnet ist;
eine Trennplatte (26), die auf der der Benutzerseite (10a) abgewandten Seite der Abdeckplatte (10) angeordnet ist und in den Bereichen zwischen der Anzahl der Bedienabschnitte (12) der Abdeckplatte (10) die Abdeckplatte kontaktierende Stützwände (28) aufweist; und
eine Anzahl Sensoren (16, 18), die auf der Trägerplatte (14) angeordnet ist und
derart ausgestaltet und angeordnet ist, dass sie jeweils eine Abstandsänderung zur Abdeckplatte (10) im Bereich eines der Anzahl der Bedienabschnitte (12) der Abdeckplatte (10) erfassen können;
wobei die Anzahl der Sensoren (16, 18) auf der der Abdeckplatte (10) zugewandten Seite der Trägerplatte (14) angeordnet ist;
auf der der Abdeckplatte (10) zugewandten Seite der Trägerplatte (14) ein Sensorgehäuse (20) angeordnet ist, das eine Anzahl Aussparungen (22a, 22b) aufweist, in denen die Anzahl Sensoren (16, 18) aufgenommen ist; und
die Trägerplatte (14), das Sensorgehäuse (20) und die Trennplatte (26) eine Baueinheit bilden, die vorzugsweise lösbar mit der Abdeckplatte (10) verbunden ist.

2. Bedienvorrichtung nach Anspruch 1,
**dadurch gekennzeichnet, dass**
das Sensorgehäuse (20) und die Trennplatte (26) integral miteinander ausgebildet sind.

3. Bedienvorrichtung nach Anspruch 1,
**dadurch gekennzeichnet, dass**
die Trägerplatte (14) und das Sensorgehäuse (20) eine erste Baueinheit bilden und die Trennplatte (26) und die Abdeckplatte (10) eine zweite Baueinheit bilden, wobei die erste Baueinheit und die zweite Baueinheit vorzugsweise lösbar miteinander verbunden sind.

4. Bedienvorrichtung nach einem der Ansprüche 1 bis 3,
**dadurch gekennzeichnet, dass**
die Anzahl Sensoren (16, 18) ausgestaltet ist, um eine Abstandsänderung zur Abdeckplatte (10) mittels elektromagnetischer Strahlung (E, R1, R2) zu erfassen; die Abdeckplatte (10) auf ihrer der Benutzerseite (10a) abgewandten Seite zumindest im Bereich der Anzahl der Bedienabschnitte (12) mit einer Reflexionsfläche (10b) ausgebildet ist; und
die Trennplatte (26) im Bereich der Bedienabschnitte (12) Öffnungen aufweist.

5. Bedienvorrichtung nach einem der Ansprüche 1 bis 3,
**dadurch gekennzeichnet, dass**
die Anzahl Sensoren (16, 18) ausgestaltet ist, um eine Abstandsänderung zur Abdeckplatte (10) mittels elektromagnetischer Strahlung (E, R1, R2) zu erfassen; die Trennplatte (26) auf ihrer der Abdeckplatte (10) zugewandten Seite eine Deckplatte (30) zum Schließen der Trennplatte (26) aufweist, die mit der Abdeckplatte (10) im Bereich der Bedienabschnitte (12) in Kontakt steht; und
die Deckplatte (30) der Trennplatte (26) auf ihrer der Benutzerseite (10a) abgewandten Seite zumindest im Bereich der Bedienabschnitte (12) mit einer Reflexionsfläche (30b) ausgebildet ist.

6. Bedienvorrichtung nach einem der vorhergehenden Ansprüche,
**dadurch gekennzeichnet, dass**
die Anzahl Sensoren (16, 18) jeweils einen Sender (16) zum Emittieren von elektromagnetischer Strahlung (E) und einen Empfänger (18) zum Erfassen der elektromagnetischen Strahlung (R1, R2) aufweist; und
die Empfänger (18) der Anzahl der Sensoren (16, 18) jeweils derart angeordnet und/oder ausgestaltet sind, dass sie eine ortsaufgelöste Erfassung der von dem Sender (16) emittierten und dann reflektierten elektromagnetischen Strahlung (R1, R2) ermöglichen.

7. Bedienvorrichtung nach Anspruch 6,
**dadurch gekennzeichnet, dass**
die Stützwände (28) der Trennplatte (26) für die von den Sendern (16) der Anzahl der Sensoren (16, 18) emittierte elektromagnetische Strahlung (E) im Wesentlichen undurchlässig ausgebildet sind.

8. Bedienvorrichtung nach einem der vorhergehenden Ansprüche,
**dadurch gekennzeichnet, dass**
auf der Trägerplatte (14) wenigstens eine Lichtquelle (32) angeordnet ist;
die Abdeckplatte (10) wenigstens einen lichtdurchlässigen Abschnitt (36) aufweist; und
wenigstens ein Lichtleitelement (34) vorgesehen ist, das von der wenigstens einen Lichtquelle (32) emittiertes Licht zu dem wenigstens einen lichtdurchlässigen Abschnitt (36) der Abdeckplatte (10) leitet, wobei das wenigstens eine Lichtleitelement (34) vorzugsweise integral mit dem Sensorgehäuse (20) und/oder der Trennplatte (26) ausgebildet ist.

9. Bedienvorrichtung nach einem der vorhergehenden Ansprüche,
**dadurch gekennzeichnet, dass**
die Stützwände (28) formstabil sind.

10. Elektronisches Haushaltsgerät mit wenigstens einer Bedienvorrichtung nach einem der vorhergehenden Ansprüche.

## Claims

1. Operator control apparatus, in particular for an electronic domestic appliance, having:
a covering plate (10) with a user side (10a) which faces a user, wherein the covering plate (10) defines a number of operator control sections (12) which are separated from one another and is designed to be elastically deformable and/or movable in these operator control sections (12);
a support plate (14) which is arranged on a side of the covering plate (10), which side is averted from the user side (10a), at a distance from said covering plate;
a separating plate (26) which is arranged on that side of the covering plate (10) which is averted from the user side (10a) and which separating plate, in the regions between the number of operator control sections (12) of the covering plate (10), has supporting walls (28) which make contact with the covering plate; and
a number of sensors (16, 18) which are arranged on the support plate (14) and are designed and arranged in such a way that said sensors can each detect a change in distance from the covering plate (10) in the region of one of the number of operator control sections (12) of the covering plate (10);
wherein
the number of sensors (16, 18) are arranged on that side of the support plate (14) which faces the covering plate (10) ;
a sensor housing (20) is arranged on that side of the support plate (14) which faces the covering plate (10), said sensor housing having a number of cutouts (22a, 22b) in which the number of sensors (16, 18) are accommodated; and
the support plate (14), the sensor housing (20) and the separating plate (26) form a structural unit which is preferably detachably connected to the covering plate (10) .

2. Operator control apparatus according to Claim 1, **characterized in that**
the sensor housing (20) and the separating plate (26) are integrally formed with one another.

3. Operator control apparatus according to Claim 1, **characterized in that**
the support plate (14) and the sensor housing (20) form a first structural unit, and the separating plate (26) and the covering plate (10) form a second structural unit, wherein the first structural unit and the second structural unit are preferably detachably connected to one another.

4. Operator control apparatus according to one of Claims 1 to 3,
**characterized in that**
the number of sensors (16, 18) are designed in order to detect a change in distance from the covering plate (10) by means of electromagnetic radiation (E, R1, R2);
the covering plate (10), on its side which is averted from the user side (10a), is formed with a reflection area (10b) at least in the region of the number of operator control sections (12); and
the separating plate (26) has openings in the region of the operator control sections (12).

5. Operator control apparatus according to one of Claims 1 to 3,
**characterized in that**
the number of sensors (16, 18) are designed in order to detect a change in distance from the covering plate (10) by means of electromagnetic radiation (E, R1, R2);
the separating plate (26), on its side which faces the covering plate (10), has a cover plate (30) for closing the separating plate (26), which cover plate is in contact with the covering plate (10) in the region of the operator control sections (12); and
the cover plate (30) of the separating plate (26), on its side which is averted from the user side (10a), is formed with a reflection area (30b) at least in the region of the operator control sections (12).

6. Operator control apparatus according to one of the preceding claims,
**characterized in that**
the number of sensors (16, 18) each have a transmitter (16) for emitting electromagnetic radiation (E) and a receiver (18) for detecting the electromagnetic radiation (R1, R2); and
the receivers (18) of the number of sensors (16, 18) are each arranged and/or designed in such a way that they allow spatially resolved detection of the electromagnetic radiation (R1, R2) which is emitted by the transmitter (16) and then reflected.

7. Operator control apparatus according to Claim 6, **characterized in that**
the supporting walls (28) of the separating plate (26) are designed to be substantially impermeable to the electromagnetic radiation (E) which is emitted by the transmitters (16) of the number of sensors (16, 18).

8. Operator control apparatus according to one of the preceding claims,
**characterized in that**
at least one light source (32) is arranged on the support plate (14);
the covering plate (10) has at least one transparent section (36); and
at least one light guide element (34) is provided which guides light which is emitted by the at least one light source (32) to the at least one transparent section (36) of the covering plate (10), wherein the at least one light guide element (34) is preferably integrally formed with the sensor housing (20) and/or the separating plate (26) .

9. Operator control apparatus according to one of the preceding claims,
**characterized in that**
the supporting walls (28) are dimensionally stable.

10. Electronic domestic appliance comprising at least one operator control apparatus according to one of the preceding claims.

## Revendications

1. Dispositif de commande, en particulier pour un appareil ménager électronique, présentant :
une plaque de recouvrement (10) dotée d'un côté utilisateur (10a) tourné vers un utilisateur, la plaque de recouvrement (10) définissant une série de parties de commande (12) séparées les unes des autres et étant configurées de manière élastiquement déformable et/ou mobile dans ces parties de commande (12) ;
une plaque de support (14) qui est disposée sur et à distance d'un côté détourné du côté utilisateur (10a) de la plaque de recouvrement (10) ;
une plaque de séparation (26) qui est disposée sur le côté détourné du côté utilisateur (10a) de la plaque de recouvrement (10) et présente dans les zones entre la série de parties de commande (12) de la plaque de recouvrement (10) des parois de soutien (28) en contact avec la plaque de recouvrement ; et
une série de capteurs (16, 18) qui sont disposés sur la plaque de support (14) et sont disposés et configurés de telle sorte qu'ils peuvent détecter respectivement une variation de distance par rapport à la plaque de recouvrement (10) au niveau de la série de parties de commande (12) de la plaque de recouvrement (10) ;
dans lequel la série de capteurs (16, 18) est disposée sur le côté tourné vers la plaque de recouvrement (10) de la plaque de support (14) ;
sur le côté tourné vers la plaque de recouvrement (10) de la plaque de support (14) est disposé un boîtier de capteur (20) qui présente une série d'évidements (22a, 22b) dans lesquels est reçue la série de capteurs (16, 18) ; et
la plaque de support (14), le boîtier de capteur (20) et la plaque de séparation (26) formant une unité modulaire qui est reliée de préférence de manière amovible à la plaque de recouvrement (10).

2. Dispositif de commande selon la revendication 1, **caractérisé en ce que** le boîtier de capteur (20) et la plaque de séparation (26) sont réalisés de manière intégrale.

3. Dispositif de commande selon la revendication 1, **caractérisé en ce que** la plaque de support (14) et le boîtier de capteur (20) forment une première unité modulaire, et la plaque de séparation (26) et la plaque de recouvrement (10) forment une deuxième unité modulaire, la première unité modulaire et la deuxième unité modulaire étant reliées ensemble de préférence de manière amovible.

4. Dispositif de commande selon l'une quelconque des revendications précédentes 1 à 3, **caractérisé en ce que** la série de capteurs (16, 18) est configurée pour détecter une variation de distance par rapport à la plaque de recouvrement (10) au moyen d'un rayonnement électromagnétique (E, R1, R2) ;
la plaque de recouvrement (10) est réalisée avec une surface réfléchissante (10b) sur son côté détourné du côté utilisateur (10a), au moins au niveau de la série des parties de commande (12) ; et
la plaque de séparation (26) présente des ouvertures au niveau des parties de commande (12).

5. Dispositif de commande selon l'une quelconque des revendications 1 à 3, **caractérisé en ce que** la série de capteurs (16, 18) est configurée pour détecter une variation de distance par rapport à la plaque de recouvrement (10) au moyen d'un rayonnement électromagnétique (E, R1, R2) ;
la plaque de séparation (26) présente sur son côté tourné vers la plaque de recouvrement (10) une plaque de recouvrement (30) pour fermer la plaque de séparation (26) qui est en contact avec la plaque de recouvrement (10) au niveau des parties de commande (12) ; et
la plaque de recouvrement (30) de la plaque de séparation (26) est réalisée avec une surface réfléchissante (30b) sur son côté détourné du côté utilisateur (10a), au moins au niveau des parties de commande (12).

6. Dispositif de commande selon l'une quelconque des revendications précédentes, **caractérisé en ce que** la série de capteurs (16, 18) présente respectivement un émetteur (16) pour émettre un rayonnement électromagnétique (E) et un récepteur (18) pour détecter le rayonnement électromagnétique (R1, R2) ; et les récepteurs (18) de la série de capteurs (16, 18) sont respectivement disposés et/ou configurés de telle sorte qu'ils permettent une détection à résolution spatiale du rayonnement électromagnétique (R1, R2) émis par l'émetteur (16) et ensuite réfléchi.

7. Dispositif de commande selon la revendication 6, **caractérisé en ce que**
les parois de soutien (28) de la plaque de séparation (26) sont réalisées de manière substantiellement opaque pour le rayonnement électromagnétique (E) émis par les émetteurs (16) de la série de capteurs (16, 18).

8. Dispositif de commande selon l'une quelconque des revendications précédentes, **caractérisé en ce que** au moins une source de lumière (32) est disposée sur la plaque de support (14) ;
la plaque de recouvrement (10) présente au moins une partie transparente (36) ; et
au moins un élément de guidage de lumière (34) est prévu qui guide la lumière émise par ladite au moins une source de lumière (32) vers ladite au moins une partie transparente (36) de la plaque de recouvrement (10), ledit au moins un élément de guidage de lumière (34) étant de préférence réalisé intégralement avec le boîtier de capteur (20) et/ou la plaque de séparation (26) .

9. Dispositif de commande selon l'une quelconque des revendications précédentes, **caractérisé en ce que** les parois de soutien (28) sont indéformables.

10. Appareil ménager électronique comprenant au moins un dispositif de commande selon l'une quelconque des revendications précédentes.
